# EUROPEAN PATENT SPECIFICATION

(11) **EP 0 490 324 B1**
(45) Date of publication and mention of the grant of the patent: **12.03.1997**
(21) Application number: 91121103.5
(22) Date of filing: 09.12.1991
(51) Int. Cl.: H01L 21/00

(54) **Cutting system**
Schneidsystem
Système de découpage

(30) Priority: 12.12.1990 JP 409894/90; 08.08.1991 JP 222390/91
(43) Date of publication of application: 17.06.1992
(73) Proprietor: DISCO CORPORATION, Ohta-ku, Tokyo (JP)
(72) Inventor: Yukawa, Isao, Odawara-shi, Kanagawa-ken (JP); Yoshii, Masahiro, Yokohama-shi, Kanagawa-ken (JP); Sekiya, Kazuma, Minato-ku, Toyko (JP)
(74) Representative: Dr. Elisabeth Jung Dr. Jürgen Schirdewahn Dipl.-Ing. Claus Gernhardt

(56) References cited:
- EP-A- 0 032 120
- US-A- 4 696 712
- US-A- 4 856 904
- WORLD PATENTS INDEX LATEST Week 8447, Derwent Publications Ltd., London, GB; AN 84-290260 & ES-8 404 899
- PATENT ABSTRACTS OF JAPAN vol. 6, no. 147 (E-123)(1025) 6 August 1982 ; & JP-A-57 071 146

## Description

### BACKGROUND OF THE INVENTION

### 1. Field of the Invention

The present invention relates to a cutting system for detecting the size, shape, and position of a workpiece and suitably cutting the workpiece according to the detected information, particularly, a cutting system is including a dicing system for holding indeterminate-shape or disorderly semiconductor wafers with a specified frame, suitably aligning the wafers according to the detected information, and suitably cutting them with a specified blade installed .

### 2. Description of the Prior Art

An aligning system for dicing (cutting) a workpiece such as a semiconductor wafer consisting of the structure disclosed in the official gazette of for example, Japanese Patent Laid-open Publication No. 60-244803 is generally known as an embodiment according to the prior art.

For the above invention according to the prior art, semiconductor wafers with regular size and shape such as those with the diameter of 125 mm (5") or 150 mm (6") are properly held by a frame respectively and provided with pattern matching and alignment at the pixel density of the X-Y-axis matrix caught by a camera according to the optimum alignment stroke previously set to said wafer with regular size.

For dicing, alignment is necessary to accurately align the cutting line (street) of a semiconductor wafer with the blade for cutting the wafer. To improve the alignment accuracy, it is necessary to execute pattern matching at two separate places (alignment stroke) on a wafer. In a conventional method, for an indeterminate-shape wafer such as a broken wafer, pattern matching may not be executed within the alignment stroke. In this case, it is necessary to change the alignment stroke manually. When a plurality of wafers are present on a frame, it is necessary to set the alignment stroke every wafer.

Therefore, for the above embodiment according to the prior art, alignment can automatically be executed only when wafers have regular size and shape, and one wafer is properly held by one frame. However, if workpieces of the same type with different sizes (e.g. 5" and 6") are supplied to a production line, it is necessary to manually select the condition meeting each workpiece. In this case, selection of condition greatly decreases the efficiency of continuous automatic operation.

In addition, in order to prevent expensive wafers from wasting, partially broken wafers are formed into chips by separating usable portions from unusable ones. In this case, however, automatic cutting is impossible. Therefore, manual alignment is executed before cutting. Especially when a plurality of indeterminate-shape and disorderly wafers are held by one frame, it is impossible to automatically align and cut individual wafer.

Therefore, the embodiment according to the prior art has the problem to be solved in automatically dicing disorderly wafers of different shapes in order to improve operability.

### SUMMARY OF THE INVENTION

In order to solve the problem of the embodiment according to the prior art, the present invention provides a cutting cutting method and cutting apparatus as outlined in the claims.

The size, shape, quantity, and position of the wafers mounted on a frame are detected by the first detecting means on an X-Y-axis matrix (e.g. X-Y-axis matrix consisting of 256x256 pixels of a CCD camera), the detected information is stored as data on a memory, each wafer is accurately aligned by the second detecting means according to the data, the cutting stroke is specified at the same time, therefore wafers with different sizes and shapes, for which it is impossible to be aligned by the conventional pattern matching, are automatically and suitably cut (diced).

### BRIEF DESCRIPTION OF THE DRAWINGS

Fig. 1 is an explanatory drawing schematically showing the first embodiment of the dicing system of the present invention;
Fig. 2 is a top view of the frame having a plurality of indeterminate-shape and disorderly wafers;
Fig. 3 is an explanatory drawing showing the X-directional cutting stroke for a wafer;
Fig. 4 is an explanatory drawing showing the Y-directional cutting stroke for a wafer;
Fig. 5 is an explanatory drawing schematically showing the second embodiment of the dicing system of the present invention;
Fig. 6 is a flow chart showing the dicing step of the dicing system of the present invention;
Fig. 7 is an explanatory drawing showing another embodiment of the workpiece detecting means applicable to the cutting and dicing system of the present invention;
Fig. 8 is an explanatory drawing for detection according to level difference detected by the detecting means of another embodiment shown in Fig. 7; and
Fig. 9 is a graph for explaining plotting of positions by the level difference detected by the detecting means of another embodiment shown in Fig. 7.

### DESCRIPTION OF SYMBOLS

- 1 :: Control section
- 2 :: First detecting means
- 3 :: Second detecting means including an alignment means
- 4 :: First position
- 5 :: Second position
- 6, 6a, 6b, 6c:: Wafer
- 6d:: Workpiece
- 7 :: Base or table
- 8 :: Cutting means
- 9 :: Frame
- 10 :: Film
- 10a:: Holding means
- 11 :: Detecting means
- A :: Cutting area

### DESCRIPTION OF THE PREFERRED EMBODIMENTS

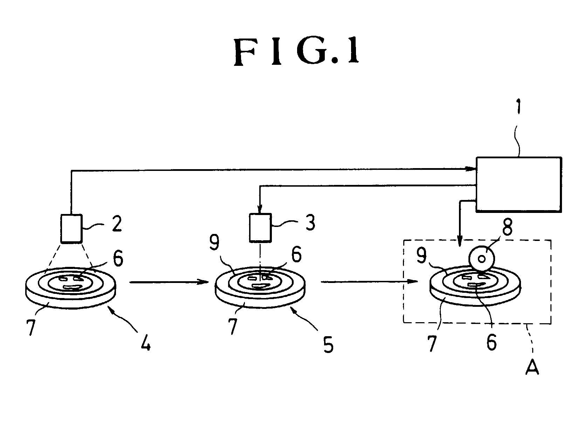

In the embodiment shown in Fig. 1, numeral 1 is a control section including a storage section. The control section 1 controls the first detecting means 2, second detecting means 3, and cutting means 8. The first detecting means 1 is installed at the first detecting position 4 and the second detecting means 3 is installed at the second detecting position 5. At the first detecting position, the size, shape, position, and quantity of wafers 6 are detected. At the second detecting position, wafers are accurately aligned to be cut. For example, a CCD camera consisting of 256x256 pixels is used as these detecting means. The wafer 6 is held on the specified holding means such as a base or table 7 and cut by the specified cutting means, i.e. the blade 8 in the cutting area A according to the data consisting of the information by the detecting means.

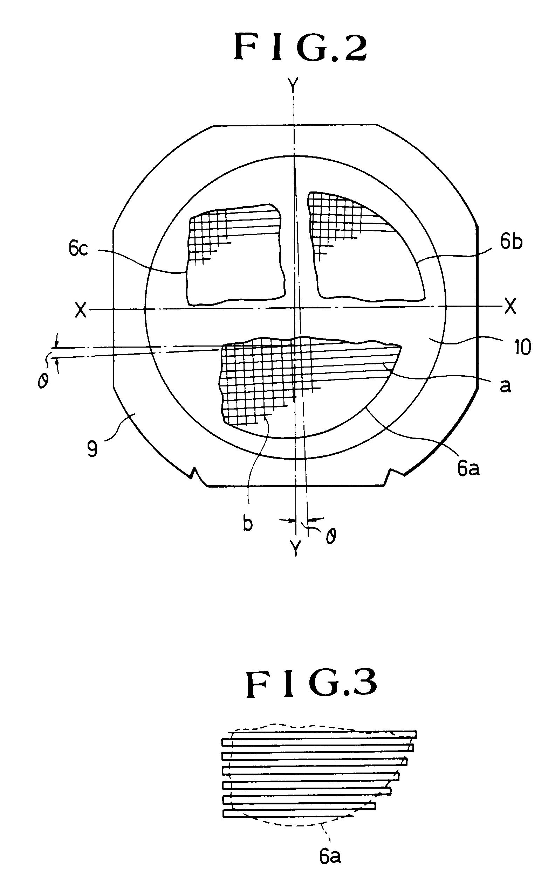

For the wafer 6, as shown in Fig. 2, for example, three wafers of 6a, 6b, and 6c are mounted on a frame 9. These wafers are partially chipped and their shapes and sizes are disorderly and indeterminate, which are mounted on the frame by visually arranging the cutting streets "a" and "b" of each wafer. Numeral 10 is a film for mounting wafers.

The frame 9 having the wafers 6a, 6b and 6c is entirely picked up by the first detecting means 2 at the first detecting position 4 to detect the wafer state. In this case, the size, shape, and quantity of wafers mounted on the frame 9 are detected on the X-Y-axis matrix. In addition, approximate tilt angle "Θ" of the cutting street is detected by the known means as shown in the official gazette of Japanese Patent Laid-open Publication No. 60-54454 according to necessity and further the position of the wafers 6a, 6b and 6c on the X-Y-axis matrix are detected. Then, the information for the alignment stroke and cutting stroke according to the above-mentioned are stored in the control section 1.

At the second detecting position 5, the wafers 6a, 6b and 6c are accurately aligned at their positions by the known pattern-matching means as shown in the above-mentioned prior art according to the information obtained at the first detecting position 4, and alignment information is detected.

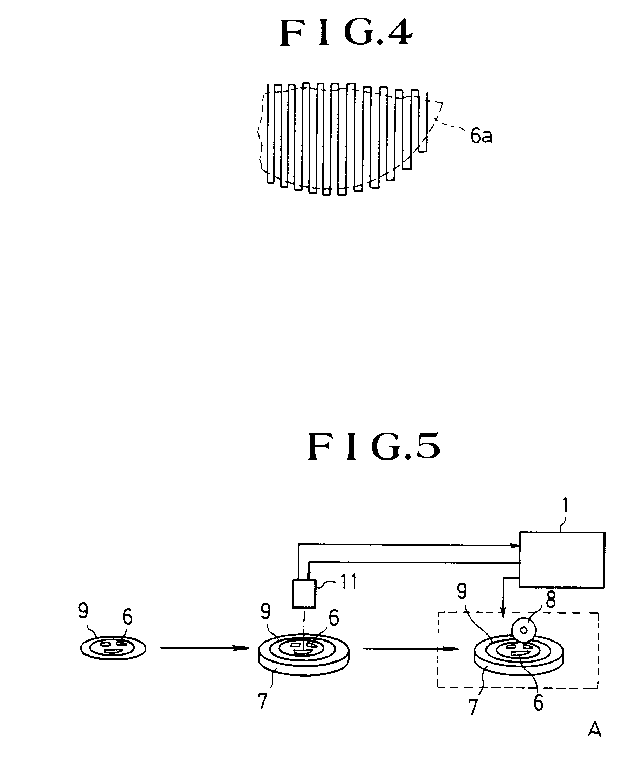

That is, such steps are comprising, for example, detecting accurately how the displacement and tilt angle on the X-Y-axis of the cutting streets "a" and "b" of the wafer 6a on the frame 9 are, storing such data as information, also detecting the cutting strokes of the cutting means 8 in the X-axis direction as shown in Fig. 3 and the Y-axis direction as shown in Fig. 4 according to the size and shape of the wafer 6a based on the information obtained at the first detecting means, and storing the both detected informations in the control section 1. Similarly, the displacement, tilt angle and cutting stroke of other wafers 6b and 6c are detected and stored in the control section 1.

The first detecting means 2 may be formed as an independent unit or installed in other unit. For example, the first detecting means may be installed in a unit for mounting the wafers on the frame 9, so-called wafer mounting unit, or installed in the dicing unit together with or separately from the second detecting means 3.

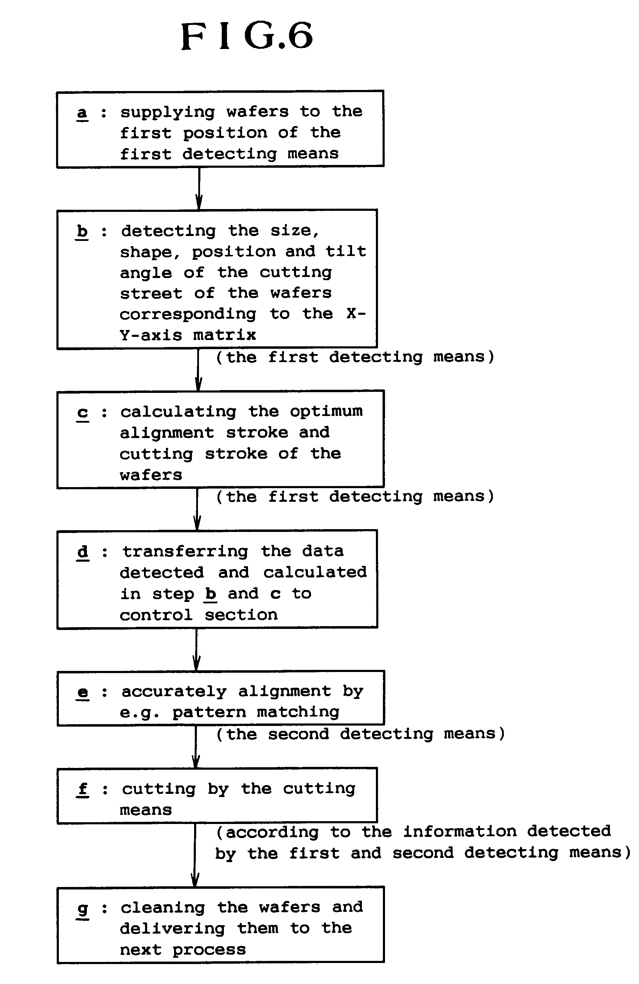

The above example is shown in Fig. 5. That is, the first and second detecting means are integrated as a detecting means 11. A CCD camera similarly to the above-mentioned may be used as the detecting means 11. Then, the size and shape of the wafers mounted on the frame 9 and the position of each wafer on the X-Y-axis matrix (e.g. matrix consisting of 256x256 pixels of a CCD camera) are detected and are stored in the control section 1 as information.

At the same time, the tilt angle of the cutting street of each wafer on the X-Y-axis matrix is detected and the cutting stroke is also detected corresponding to the size and shape of each wafer. These pieces of information are stored in the control section 1. The frame 9 is mounted on a base or table 7 and wafers are suitably cut by the cutting means 8 in the cutting area A, similarly to the procedure for the above embodiment.

For the above embodiment, the size, shape, position, quantity and cutting street of one or more wafers mounted on the frame 9 are detected on the X-Y-axis matrix, and, at the same time, the cutting stroke is also detected corresponding to the size and shape of the wafers. Accordingly, cutting (dicing) is accurately and securely executed according to these pieces of information.

The following is the description of dicing for the system of the present invention according to the flow chart in Fig. 6. In the first step **a**, one or more wafers mounted on the frame 9 are supplied to the first position 4 of the first detecting means 2. In the second step **b**, the state of the wafer is detected by the first detecting means 2 at the first position 4. That is, the size, shape, position, and tilt angle of the cutting street of the wafers corresponding to the X-Y-axis matrix are detected as information.

In the third step **c**, the optimum alignment stroke and cutting stroke of the wafers are calculated according to the detected information for the size, shape, position and tilt angle of cutting street corresponding to the X-Y-axis matrix. In the fourth step **d**, the data detected in the second step **b** and calculated in the third step **c** is transferred to and stored in the control section 1 as information.

In the fifth step **e**, each wafer on the frame is accurately aligned by the second detecting means 3, e.g. pattern matching means with the optimum alignment stroke according to the information in the first detecting means 2 and the alignment information is stored in the control section 1. In the sixth step **f**, the wafers are cut at the cutting area A according to the cutting-stroke information obtained by the first detecting means 2 and stored in the control section 1 and the alignment information obtained by the second detecting means 3 and stored in the control section 1. And in the seventh step **g**, the cut wafers are cleaned after the end of the dicing process and the frames having the cleaned wafers are delivered to the next process.

The second step **b** through the fifth step **e** are executed by one detecting means 11 made by integrating the first and second detecting means and the sixth **f** and seventh **g** steps are executed in order according to the data detected by the detecting means 11. The above steps are repeated every supplied frame. Therefore, suitable dicing can continuously be executed even if the size, shape, and quantity (one or more) of wafers mounted on each frame are different.

In the above embodiment, a CCD camera is used as detecting means, however, the detecting means is not limited, e.g. various types of detecting means including ultrasonic detecting means, laser beam detecting means and so on may be used.

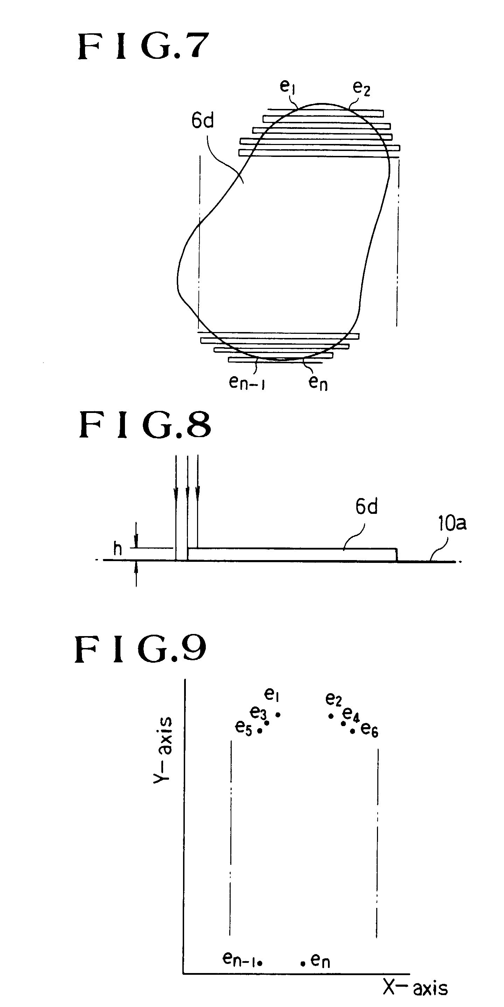

In this case, the size, shape, and position of a workpiece are detected by the ultrasonic or laser-beam detecting means as shown in Figs. 7 through 9.

The following is the description of the above detection. The size, shape and position of the wafer 6d are detected by detecting the level difference "h" between the wafer 6d and the holding means 10a for holding the wafer according to scanning them by the detecting means or detecting the difference of reflected luminous energy (Figs. 7 and 8) and plotting the boundary points (e1, e2,..., and en) between the wafer 6d and the holding means 10a on the X-Y coordinate axis (X-Y-axis matrix) (Fig. 9). Then, cutting is executed.

In addition, combination of different types of detecting means such as combination of the CCD camera and the ultrasonic or laser-beam detecting means is included in the technical idea of the present invention unless the combination contradicts the gist of the present invention.

### ADVANTAGES OF THE INVENTION

First, the cutting and dicing system of the present invention comprises a frame for holding wafers, first detecting means for detecting the size, shape and position of the wafer held by the frame on an X-Y-axis matrix, second detecting means for aligning the wafers according to the information detected by the first detecting means, and cutting means for cutting the wafers according to the information detected by the second detecting means, wherein the size, shape and position of indeterminate-shape and disorderly wafers are detected by the first detecting means on an X-Y-axis matrix, the wafers are accurately aligned by the second detecting means according to the detected information, and one or more indeterminate-shape wafers are automatically and accurately diced though they are only manually diced conventionally.

Secondly, the first detecting means detects the size, shape and position of a wafer on an X-Y-axis matrix and the cutting stroke is controlled according to the information detected by the first detecting means. Accordingly, it is confirmed that the cutting efficiency is improved and the throughput is increased up to 1.5 times compared with the conventional throughput. Even if a plurality of wafers are mounted on one frame, each wafer can be cut (diced) without moving unnecessarily and being affected by other wafers.

Thirdly, it is possible to install the second detecting means and cutting means in the same unit, the first detecting means, independently or in other unit, or the first detecting means, second detecting means and cutting means in the same unit. It is also possible to make the first and second detecting means common. Accordingly, it is possible to simply upgrade the conventional dicing systems.

## Claims

1. A method for continuously cutting a possible plurality of possibly irregular-shaped semiconductor wafers each having cutting streets thereon, comprising the steps of:
(a) mounting one or more semiconductor wafers (6, 6a, 6b, 6c) on a frame (9);
(b) detecting size, shape, and position of each semiconductor wafer (6, 6a, 6b, 6c) and the quantity of the semiconductor wafers on the frame (9) with a first detecting means (2) along an X-Y axis matrix;
(c) calculating the optimum alignment stroke and cutting stroke of each semiconductor wafer (6, 6a, 6b, 6c) on the basis of the information detected by the first detecting means (2) as cutting-stroke information;
(d) transferring and storing the cutting-stroke information calculated in step (c) to a control section (1);
(e) aligning each semiconductor wafer (6, 6a, 6b, 6c) according to the information detected by the first detecting means (2) and detecting alignment information with a second detecting means (3) including an alignment means;
(f) transferring and storing the alignment information detected in step (e) in the control section (1);
(g) cutting each semiconductor wafer (6, 6a, 6b, 6c) by a cutting means (8) according to the cutting-stroke and alignment information stored in steps (d) and (f); and
(h) repeating the above steps for every supplied frame (9).

2. A cutting apparatus for performing the method of claim 1, comprising:
at least one frame (9) for holding two or more semiconductor wafers (6, 6a, 6b, 6c);
first detecting means (2) for detecting size, shape and position of each semiconductor wafer (6, 6a, 6b, 6c) and a quantity of the semiconductor wafers held by the frame (9) as cutting-stroke information;
second detecting means including an alignment means (3) for accurately aligning the position of each semiconductor wafer (6, 6a, 6b, 6c) according to the cutting-stroke information detected by the first detecting means (2) and for detecting alignment information of each semiconductor wafer (6, 6a, 6b, 6c);
control section (1) for storing the quantity, size, shape and position of the semiconductor wafers (6, 6a, 6b, 6c) detected by the first detecting means (2) and the alignment information detected by the second detecting means (3);
cutting means (8) for cutting each semiconductor wafer (6, 6a, 6b, 6c) according to the cutting-stroke information detected by the first detecting means (2) and the alignment information detected by the second detecting means (3).

3. A cutting apparatus according to claim 2, wherein the second detecting means (3) and the cutting means (8) are installed together in a first unit and the first detecting means (2) is installed in a second unit.

4. A cutting apparatus according to claim 2, wherein the first detecting means (2), the second detecting means (3) and the cutting means (8) are installed in a single unit.

5. A cutting apparatus according to claim 2, wherein the first detecting means and the second detecting means are common as a single detecting means (11).

## Patentansprüche

1. Verfahren zum kontinuierlichen Schneiden einer möglichen Mehrzahl von möglicherweise unregelmäßig geformten Halbleiter-Wafern, die jeweils Schneidstraßen darauf aufweisen, das folgende Schritte umfaßt:
(a) Montieren eines oder mehrerer Halbleiter-Wafer (6, 6a, 6b, 6c) auf einem Gestell (9);
(b) Erfassen der Größe, Form und Position jedes Halbleiter-Wafers (6, 6a, 6b, 6c) und der Anzahl der Halbleiter-Wafer auf dem Gestell (9) mit einer ersten Erfassungseinrichtung (2) bezüglich einer X-Y-Achsenmatrix;
(c) Berechnen des optimalen Ausrichtungshubs und Schneidhubs jedes Halbleiter-Wafers (6, 6a, 6b, 6c) auf der Basis der von der ersten Erfassungseinrichtung (2) als Schneidhubinformation erfaßten Information;
(d) Übertragen und Speichern der in Schritt (c) berechneten Schneidhubinformation zu einem Steuerabschnitt (1);
(e) Ausrichten jedes Halbleiter-Wafers (6, 6a, 6b, 6c) entsprechend der von der ersten Erfassungseinrichtung (2) erfaßten Information und Erfassen von Ausrichtungsinformation mit einer eine Ausrichtungseinrichtung enthaltenden zweiten Erfassungseinrichtung (3);
(f) Übertragen und Speichern der in Schritt (e) erfaßten Ausrichtungsinformation in den Steuerabschnitt (1);
(g) Schneiden jedes Halbleiter-Wafers (6, 6a, 6b, 6c) durch eine Schneideinrichtung (8) entsprechend der in den Schritten (d) und (f) gespeicherten Schneidhub- und Ausrichtungsinformation; und
(h) Wiederholen der obigen Schritte für jedes gelieferte Gestell (9).

2. Schneidvorrichtung zur Durchführung des Verfahrens von Anspruch 1 mit:
zumindest einem Gestell (9) zum Halten zweier oder mehrerer Halbleiter-Wafer (6, 6a, 6b, 6c);
einer ersten Erfassungseinrichtung (2) zum Erfassen der Größe, Form und Position jedes Halbleiter-Wafers (6, 6a, 6b, 6c) und der Anzahl der von dem Gestell (9) gehaltenen Halbleiter-Wafer als Schneidhubinformation;
einer eine Ausrichtungseinrichtung enthaltenden zweiten Erfassungseinrichtung (3) zum präzisen Ausrichten der Position jedes Halbleiter-Wafers (6, 6a, 6b, 6c) entsprechend der von der ersten Erfassungseinrichtung (2) erfaßten Schneidhubinformation und zum Erfassen von Ausrichtungsinformation jedes Halbleiter-Wafers (6, 6a, 6b, 6c);
einem Steuerabschnitt (1) zum Speichern der von der ersten Erfassungseinrichtung (2) erfaßten Anzahl, Größe, Form und Position jedes Halbleiter-Wafers (6, 6a, 6b, 6c) und der von der zweiten Erfassungseinrichtung (3) erfaßten Ausrichtungsinformation;
einer Schneideinrichtung (8) zum Schneiden jedes Halbleiter-Wafers (6, 6a, 6b, 6c) entsprechend der von der ersten Erfassungseinrichtung (2) erfaßten Schneidhubinformation und der von der zweiten Erfassungseinrichtung (3) erfaßten Ausrichtungsinformation.

3. Schneidvorrichtung nach Anspruch 2, bei der die zweite Erfassungseinrichtung (3) und die Schneideinrichtung (8) zusammen in einer ersten Einheit installiert und die erste Erfassungseinrichtung (2) in einer zweiten Einheit installiert ist.

4. Schneidvorrichtung nach Anspruch 2, bei der die erste Erfassungseinrichtung (2), die zweite Erfassungseinrichtung (3) und die Schneideinrichtung (8) in einer einzigen Einheit installiert sind.

5. Schneidvorrichtung nach Anspruch 2, bei der die erste Erfassungseinrichtung und die zweite Erfassungseinrichtung als eine einzige Erfassungseinrichtung (11) gemeinsam ausgebildet sind.

## Revendications

1. Procédé pour découper en continu une éventuelle pluralité de plaquettes de semi-conducteur éventuellement de forme irrégulière, chacune y ayant des passages de découpage, comprenant les étapes consistant à:
(a) installer une ou plusieurs plaquettes de semi-conducteur (6, 6a, 6b, 6c) sur un cadre (9);
(b) détecter la dimension, forme, et position de chaque plaquette de semi-conducteur (6, 6a, 6b, 6c) et la quantité des plaquettes de semi-conducteur sur le cadre (9) avec des premiers moyens de détection (2) le long d'une matrice des axes XY;
(c) calculer la course d'alignement optimale et la course de découpage de chaque plaquette de semi-conducteur (6, 6a, 6b, 6c) sur la base de l'information détectée par les premiers moyens de détection (2) comme une information de course de découpage;
(d) transférer et stocker l'information de course de découpage calculée à l'étape (c) dans une unité de commande (1) ;
(e) aligner chaque plaquette de semi-conducteur (6, 6a, 6b, 6c) selon l'information détectée par les premiers moyens de détection (2), et détecter l'information d'alignement avec des deuxièmes moyens de détection (3) incluant des moyens d'alignement;
(f) transférer et stocker l'information d'alignement détectée à l'étape (e) dans l'unité de commande (1) ;
(g) découper chaque plaquette de semi-conducteur (6, 6a, 6b, 6c) par des moyens de découpage (8) selon l'information de course de découpage et l'information d'alignement stockées aux étapes (d) et (f); et
(h) répéter les étapes ci-dessus pour chaque cadre fourni (9).

2. Appareil de découpage pour effectuer le procédé de la revendication 1, comprenant:
au moins un cadre (9) pour maintenir deux plaquettes de semi-conducteur ou plus (6, 6a, 6b, 6c);
des premiers moyens de détection (2) pour détecter la dimension, forme et position de chaque plaquette de semi-conducteur (6, 6a, 6b, 6c) et une quantité de plaquettes de semi-conducteur maintenues par le cadre (9) comme une information de course de découpage;
des deuxièmes moyens de détection incluant des moyens d'alignement (3) pour aligner précisément la position de chaque plaquette de semi-conducteur (6, 6a, 6b, 6c) selon l'information de course de découpage détectée par les premiers moyens de détection (2) et pour détecter l'information d'alignement de chaque plaquette de semi-conducteur (6, 6a, 6b, 6c);
une unité de commande (1) pour stocker la quantité, dimension, forme et position des plaquettes de semi-conducteur (6, 6a, 6b, 6c) détectées par les premiers moyens de détection (2) et l'information d'alignement détectée par les deuxièmes moyens de détection (3);
des moyens de découpage (8) pour découper chaque plaquette de semi-conducteur (6, 6a, 6b, 6c) selon l'information de course de découpage détectée par les premiers moyens de détection (2) et l'information d'alignement détectée par les deuxièmes moyens de détection (3).

3. Appareil de découpage selon la revendication 2, dans lequel les deuxièmes moyens de détection (3) et les moyens de découpage (8) sont installés ensemble dans une première unité, et les premiers moyens de détection (2) sont installés dans une deuxième unité.

4. Appareil de découpage selon la revendication 2, dans lequel les premiers moyens de détection (2), les deuxièmes moyens de détection (3) et les moyens de découpage (8) sont installés dans une seule unité.

5. Appareil de découpage selon la revendication 2, dans lequel les premiers moyens de détection et les deuxièmes moyens de détection sont réunis comme des moyens de détection uniques (11).
